# EUROPÄISCHE PATENTANMELDUNG

(11) **EP 2 835 656 A1**
(43) Veröffentlichungstag der Anmeldung: **11.02.2015**
(21) Anmeldenummer: 14179834.8
(22) Anmeldetag: 05.08.2014
(51) Int. Cl.: G01R 19/155, G01R 15/14

(54) **Spannungssensor zum kontaktlosen Messen der Spannung einer isolierten elektrischen Leitung**

(30) Priorität: 05.08.2013 DE 102013108427
(71) Anmelder: Gattermann, Markus, 94107 Untergriesbach (DE)
(72) Erfinder: Gattermann, Markus, 94107 Untergriesbach (DE)
(74) Vertreter: advotec.

(57) **Zusammenfassung**

Die Erfindung betrifft einen Spannungssensor (01) zum kontaktlosen Messen der Spannung einer isolierten elektrischen Leitung (07), umfassend eine Versorgungseinheit (03) zur Aufnahme elektrischer Leistung mit einem Versorgungseingang (08) und zumindest einem Versorgungsausgang (10), eine Messeinheit (04) mit einem Messsignalausgang (18) zur kontaktlosen Messung von Spannung, eine Aufbereitungseinheit (05) mit einem Messsignaleingang (19) sowie zumindest einem Versorgungseingang (12) und einem Verarbeitungssignalausgang (24) und einer Schalteinheit (06) mit einem Versorgungseingang (14), einem Verarbeitungssignaleingang (25) und einem Schaltausgang (26).

Die Schalteinheit (06) weist zumindest einen Schaltzustand auf, in dem die an der Versorgungseinheit (03) anliegende Spannung am Schaltausgang (26) anliegt.

## Beschreibung

Die Erfindung betrifft einen Spannungssensor zum kontaktlosen Messen der Spannung einer isolierten elektrischen Leitung gemäß dem Oberbegriff des Anspruchs 1.

Bekannte Spannungssensoren finden beispielsweise Anwendung in der Automationstechnik. Ihre Aufgabe besteht grundsätzlich darin, ohne einen physischen Eingriff in den zu vermessenden Schaltkreis bzw. ohne physischen Zugriff auf die zu vermessende elektrische Leitung den Spannungszustand des Schaltkreises bzw. der Leitung abzufragen. Dies kann beispielsweise nötig sein, um nachvollziehen zu können, ob eine Sicherung ausgelöst hat, bzw. in welchem Zustand sich eine Automationsschaltung befindet.

Aus dem Stand der Technik sind bereits kontaktlose Spannungssensoren bekannt, die beispielsweise mittels eines kapazitiven Messfühlers die Spannung einer isolierten elektrischen Leitung messen können und das Messergebnis für den Benutzer erkennbar bzw. erfassbar machen. Zur Ausgabe der entsprechenden Messung bzw. der Messergebnisse dienen dazu beispielsweise optische Anzeigen der bekannten Spannungssensoren.

Derartige Spannungssensoren sind für eine Vielzahl von Anwendungsbereichen ausreichend. Insbesondere wenn der Spannungszustand der zu vermessenden elektrischen Leitung rein informativen Charakter hat, ist es vollständig ausreichend, ein beliebiges Ausgabesignal mittels des Spannungssensors zur kontaktlosen Messung auszugeben. Die bekannten Spannungssensoren haben jedoch gleichzeitig den Nachteil, dass eine unmittelbare Weiterverarbeitung des Ausgangssignals, beispielsweise zur Ansteuerung eines Relais bzw. einer Relaisschaltung oder einer speicherprogrammierbaren Steuerung nicht erfolgen kann. Dies ist jedoch besonders wünschenswert in allen Fällen, in denen das Messergebnis über den Spannungszustand der zu messenden isolierten Leitung nicht nur rein informativen Gehalt hat, sondern mittelbar oder unmittelbar weitere Schaltungen, Schaltkomponenten oder dergleichen beeinflussen bzw. steuern soll.

Ausgehend von diesem Stand der Technik ist es daher Aufgabe der vorliegenden Erfindung, einen Spannungssensor zum kontaktlosen Messen der Spannung einer isolierten elektrischen Leitung vorzuschlagen, welcher die Nachteile des Standes der Technik überwindet und insbesondere ein Ausgangssignal des Spannungssensors erzeugt, welches zur Steuerung von Relais oder speicherprogrammierbaren Steuerungen genutzt werden kann.

Diese Aufgabe wird durch den Spannungssensor nach der Lehre des Anspruchs 1 sowie durch ein Verfahren zur kontaktlosen Spannungsmessung gemäß des Anspruchs 13 gelöst.

Vorteilhafte Ausführungsformen der Erfindung sind Gegenstand der Unteransprüche.

Die erfindungsgemäße Vorrichtung bzw. das erfindungsgemäße Verfahren beruht auf der Grundüberlegung, dass bei einem derartigen Sensor bzw. einem Verfahren zu dessen Betrieb eine zumindest auch zur Leistungsversorgung des Sensors vorgesehene externe Versorgungsspannung in Abhängigkeit des Messergebnisses einer Messeinheit an einem Sensorausgang bzw. einem Schaltausgang des Sensors zumindest mittelbar anliegt.

Dazu ist vorgesehen, dass der erfindungsgemäße Spannungssensor zum kontaktlosen Messen der Spannung einer isolierten elektrischen Leitung eine Versorgungseinheit zur Aufnahme elektrischer Leistung von einer externen Quelle mit einem entsprechenden Versorgungseingang und zumindest einem entsprechenden Versorgungsausgang aufweist. Weiter ist von dem vorgeschlagenen Spannungssensors eine Messeinheit zum kontaktlosen Messen von Spannung umfasst, die ihrerseits einen Messsignalausgang aufweist. Zudem ist eine Aufbereitungseinheit mit einem Messsignaleingang sowie zumindest einem Versorgungseingang und einem Verarbeitungssignalausgang als eines der Bestandteile des Spannungssensors vorgesehen. Zudem umfasst die vorgeschlagene Vorrichtung eine Schalteinheit, die ihrerseits einen Versorgungseingang, einen Verarbeitungssignaleingang und einen Schaltausgang aufweist, wobei die Schalteinheit zumindest einen Schaltzustand aufweist, in dem die an der Versorgungseinheit an deren Versorgungseingang anliegende Spannung ebenfalls auch am Schaltausgang der Schalteinheit und damit zumindest mittelbar am Signalausgang des Spannungssensors anliegt.

Im Allgemeinen soll davon ausgegangen werden, dass der Schaltausgang der Schalteinheit des Spannungssensors gleichzeitig auch der Ausgang bzw. Signalausgang des Spannungssensors ist. Dies bedeutet im Umkehrschluss jedoch gleichzeitig, dass es auch Teil der vorgeschlagenen Lehre ist, den Schaltausgang der Schalteinheit mit einem separaten Signalausgang des Spannungssensors zu verschalten. Jedenfalls sollen Eigenschaften und Ausgestaltungen des Schaltausgangs der Schalteinheit gemäß der vorgeschlagenen Lehre auch einem separaten, vom Schaltausgang der Schalteinheit getrennten Signalausgang des Spannungssensors zugeordnet werden können.

Die Schalteinheit kann vorteilhaft zwei Schaltzustände aufweisen, wobei in einem ersten Schaltzustand der Schaltausgang spannungslos ist und in einem zweiten Schaltzustand am Schaltausgang die am Versorgungseingang anliegende Spannung anliegt. Es kann jedoch auch vorteilhaft sein, weitere Schaltungszustände der Schalteinheit vorzusehen.

Durch die vorgeschlagene Ausgestaltung des Spannungssensors werden gleich mehrere vorteilhafte Eigenschaften realisiert bzw. Eigenschaften bekannter Sensoren verbessert. Durch Vorsehen einer Versorgungseinheit, die zur Aufnahme von elektrischer Leistung einer externen Quelle eingerichtet ist, wird der Spannungssensor in vorteilhafter Weise unabhängig von einer internen elektrischen Leistungsquelle bzw. von deren Zustand. Mit anderen Worten ausgedrückt bedeutet dies, dass der vorgeschlagene Spannungssensor durch einen Anschluss an eine externe Spannungsquelle nicht von internen Batterien, Akkumulatoren oder dergleichen sowie von deren Zustand abhängig ist. Dadurch wird eine problemlose und zuverlässige Anwendung des vorgeschlagenen Sensors, auch im Dauerbetrieb, ermöglicht. Darüber hinaus ist es zugleich überaus vorteilhaft, dass mittels der Versorgungseinheit sowie der Verbindung eines Versorgungsausgangs der Versorgungseinheit mit einem Versorgungseingang der Schalteinheit des Spannungssensors sowie einer entsprechenden Verschaltung der Schalteinheit bzw. Anordnung der Schaltzustände ermöglicht wird, in Abhängigkeit des aufbereiteten Messsignals der Messeinheit, die an der Versorgungseinheit anliegende externe Spannung als Ausgangssignal der Schalteinheit bzw. als Ausgangssignal des Sensors auszugeben. Damit wird ermöglicht, mit dem Ausgangssignal des vorgeschlagenen Spannungssensors bzw. mit der am Schaltausgang anliegenden Ausgangsspannung unmittelbar speicherprogrammierbare Steuerungen oder Relais anzusteuern.

Im Allgemeinen soll für die Beschreibung des vorliegenden Spannungssensors, insbesondere im Hinblick auf die interne Verschaltung der einzelnen Einheiten des Spannungssensors davon ausgegangen werden, dass jeweils gleich benannte Eingänge und Ausgänge unterschiedlicher Einheiten des Sensors jeweils zumindest elektrisch miteinander verbunden sind. Die Art und Weise, wie diese elektrische Verbindung zustande kommt, kann dabei höchst unterschiedlich ausfallen. In einem Extrem kann sich zwischen einem Eingang einer Einheit einerseits und einem entsprechenden Ausgang einer anderen Einheit andererseits eine elektrische Leitung mit einer endlichen Leitungslänge und endlichem elektrischen Widerstand befinden. In einem anderen Extrem kann es jedoch bei der elektrischen Verbindung zwischen Ein- und Ausgängen auch lediglich zu einer gedachten Verbindung kommen, da gemäß des Schaltungsaufbaus die entsprechenden Ausgänge und Eingänge direkt ineinander übergehen bzw. keine eindeutige Separierung erlauben. Im Allgemeinen kann vorgesehen sein, dass die Einheiten des Spannungssensors allesamt auf einer gemeinsamen Leiterplatte angeordnet sind.

Gemäß einer ersten vorteilhaften Ausgestaltung des vorgeschlagenen Spannungssensors ist vorgesehen, dass der Schaltausgang als industrietechnisch standardisierter Schaltausgang ausgelegt ist. Eine derartige Standardisierung kann durch entsprechend einfache und dem Fachmann bekannte Mittel zur Spannungs- bzw. Stromstärkenanpassung erreicht werden, so dass das am Schaltausgang anliegende Signal einem industrietechnischen Standard entspricht. Dadurch wird in vorteilhafter Weise die direkte Verwendung des Ausgangssignals des Spannungssensors für speicherprogrammierbare Steuerungen oder Relais ermöglicht. Die Mittel zur entsprechenden Anpassung des Schaltausgangs können dabei dem Schaltausgang selbst, einem etwaigen, separaten Signalausgang des Sensors oder gar einer zusätzlichen Anpassungseinheit zugeordnet sein.

Für die kontaktlose Spannungsmessung einer isolierten elektrischen Leitung ohne physische Kontaktierung dieser Leitung bieten sich grundsätzlich verschiedene Messmethoden und demnach auch verschiedene Ausgestaltungen der vorgeschlagenen Messeinheit an. Gemäß einer vorteilhaften Ausgestaltung ist jedoch vorgesehen, dass die Messeinheit ein kapazitives Messelement aufweist. Derartige Messelemente, die beispielsweise als offene Elektrode ausgebildet sein können, haben den Vorteil, dass sie hinlänglich bekannt und weit verbreitet sind und daher zu günstigen Preisen mit ausreichender Qualität und unterschiedlichsten Ausgestaltungen weitgehend vorgefertigt erhältlich sind. Andererseits lassen sich derartige Messelemente auch in bekannter und geläufiger Weise auf einem Trägermaterial, wie beispielsweise einer Leiterplatte, anordnen bzw. anbringen.

Da, wie oben bereits angesprochen, der vorgeschlagene Sensor mit seiner Versorgungseinheit zur Aufnahme elektrischer Leistung von einer externen Quelle insbesondere auch für den Dauerbetrieb, also zur dauerhaften kontaktlosen Spannungsmessung, ausgelegt ist, sieht eine weitere vorteilhafte Ausführungsform des vorgeschlagenen Spannungssensors vor, dass dieser ein Gehäuse aufweist, wobei in einer vorteilhaften Ausgestaltung das Gehäuse auf seiner Außenfläche zumindest ein Befestigungsmittel zur Befestigung der zu messenden isolierten elektrischen Leitung umfasst. Dadurch wird neben der bloßen Befestigung der zu messenden isolierten elektrischen Leitung auch eine wohl definierte räumliche Anordnung zwischen der Messeinheit und der zu messenden Leitung ermöglicht, was wiederum in vorteilhafter Weise die Verlässlichkeit sowie die Reproduzierbarkeit der Messergebnisse der Messeinheit und damit auch die Verlässlichkeit und Genauigkeit des Spannungssensors an sich beeinflusst.

Weiter sieht eine vorteilhafte Variante des vorgeschlagenen Spannungssensors vor, dass die Aufbereitungseinheit eine Verstärkungseinheit und eine Vergleichseinheit aufweist, wobei die Verstärkungseinheit das Messsignal des Messsignaleingangs verstärkt und die Vergleichseinheit einen Referenzspannungseingang aufweist und dass an einem Signaleingang der Vergleichseinheit anliegende Signal mit dem am Referenzsignaleingang anliegenden Signal vergleicht und in Abhängigkeit des Vergleichs ein Verarbeitungssignal über den Verarbeitungssignalausgang ausgibt. Dadurch wird sichergestellt, dass die Schaltung der Schalteinheit lediglich mittelbar vom Messsignal der Messeinheit abhängig ist. Die vorgeschlagene Verstärkungseinheit und Vergleichseinheit können dabei konstruktiv sowohl einheitlich als auch als tatsächlich voneinander getrennte Einheiten vorgesehen werden. Im Fall einer Verwendung einer Verstärkungseinheit und einer Vergleichseinheit ist wiederum vorgesehen, dass der Signaleingang der Vergleichseinheit mit einem Signalausgang der Verstärkungseinheit verschaltet ist.

Gemäß einer vorteilhaften Ausführung der vorgeschlagenen Vorrichtung ist vorgesehen, dass die Vergleichseinheit einen Analog-Digital-Wandler aufweist und in Abhängigkeit des Vergleichs zwischen dem Referenzsignal und dem Einganssignal ein digitales Verarbeitungssignal über den Verarbeitungssignalausgang der Aufbereitungseinheit ausgibt. Durch eine entsprechende Analog-Digital-Wandlung wird es ermöglicht, das Verarbeitungssignal, welches über den Verarbeitungssignaleingang der Schalteinheit als Schaltsignal verwendet wird wohl definiert auszugeben und damit eine entsprechend präzise Schaltung der Schalteinheit zu ermöglichen. Die Vergleichseinheit kann beispielsweise als Schmitt-Trigger ausgebildet sein.

Um eine Vielzahl unterschiedlicher isolierter elektrischer Leitungen bzw. eine Vielzahl von Zuständen solcher Leitungen mittels des vorgeschlagenen Sensors messen zu können, ist es besonders wünschenswert, die Empfindlichkeit des Sensors einstellen zu können. Demnach sieht in einer weiteren Ausführungsform der Spannungssensor eine Einstelleinheit vor, die einen Referenzsignalausgang aufweist. Mittels der Einstelleinheit wird aus der an der Versorgungseinheit anliegenden Versorgungsspannung über einen entsprechenden Versorgungsausgang der Versorgungseinheit sowie einen Versorgungseingang der Einstelleinheit das Referenzsignal erzeugt und über den Referenzsignalausgang ausgegeben. Die Einstelleinheit kann dabei als variabler elektrischer Widerstand ausgeführt sein, bei dem sich die Referenzspannung proportional zum elektrischen Widerstand ergibt.

Dazu ist vorteilhaft vorgesehen, dass der Spannungssensor ein Einstellmittel aufweist, mit dem das in der Einstelleinheit erzeugte Referenzsignal eingestellt wird. Die Einstelleinheit kann dabei derart ausgeführt sein, dass sie eine stufenlose oder stufenweise Einstellung der Einstelleinheit erlaubt. Eine stufenlose Einstellung eignet sich besonders für eine individuelle Anpassung des Sensors an die zu messende elektrisch isolierte Leitung. Eine abgestufte Einstellbarkeit des Einstellmittels erlaubt andererseits eine schnelle und einfache Anpassung des Sensors an standardisierte zu messende elektrisch isolierte Leitungen bzw. standardisierte Zustände der entsprechenden Leitungen.

Um eine möglichst flexible und kurzfristige Einstellung der Sensibilität des Spannungssensors zu ermöglichen, ist in einer vorteilhaften Ausgestaltung vorgesehen, dass das Einstellmittel ein Bedienelement aufweist, welches auf der Außenseite des Gehäuses des Sensors angebracht ist. Dadurch wird ermöglicht, dass der Bediener des Spannungssensors jederzeit die Empfindlichkeit der kontaktlosen Messung über das Bedienelement einstellen kann.

Gemäß einer weiteren Weiterbildung des erfindungsgemäßen Spannungssensors ist vorgesehen, dass dieser eine Anzeigeeinheit aufweist, welche den Schaltzustand der Schalteinheit anzeigt. Dies ermöglicht zusätzlich zu der unmittelbaren Verwendung des Ausgangssignals des Sensors als Signal für Relais bzw. speicherprogrammierbare Steuerungen zusätzlich auch das übliche bzw. herkömmliche Erfassen des Zustands der zu messenden isolierten elektrischen Leitung.

Dabei ist es besonders vorteilhaft, wenn die Anzeigeeinheit zumindest eine Leuchtdiode aufweist. Somit wird in einfacher und leicht erkennbarer Weise der Spannungszustand der zu messenden Leitung am Spannungssensor gezeigt. Alternativ dazu können jedoch auch Anzeigeeinheiten mit mehreren Leuchtdioden oder Anzeigeeinheiten ohne Leuchtdioden vorgesehen sein.

Um einen sicheren Betrieb des vorgeschlagenen Spannungssensors zu ermöglichen und um einer Beschädigung des Spannungssensors vorzubeugen, ist gemäß einer vorteilhaften Ausführungsform vorgesehen, dass die Versorgungseinheit ein Verpolschutzmittel aufweist.

Die erfindungsgemäße Aufgabe, nämlich ein Ausgangssignal eines Sensors zur kontaktlosen Spannungsmessung einer isolierten elektrischen Leitung bereitzustellen, welches wiederum unmittelbar oder zumindest mittelbar zum Betrieb von Relais oder speicherprogrammierbaren Steuerungen benutzt werden kann, wird auch durch ein Verfahren gemäß des unabhängigen Anspruchs 13 gelöst.

Das Verfahren zur kapazitiven, kontaktlosen Spannungsmessung einer isolierten elektrischen Leitung mittels eines Spannungssensors umfasst dabei folgende Verfahrensschritte:
Zunächst erfolgt die kontaktlose Messung einer isolierten elektrischen Leitung mittels einer Messeinheit und Ausgabe des Messsignals über einen Messsignalausgang der Messeinheit. Daran anschließend wird das Messsignal über einen Messsignaleingang einer Aufbereitungseinheit aufgenommen und anschließend mittels der Aufbereitungseinheit unter Verwendung einer Versorgungsspannung aufbereitet. Das aufbereitete Signal wird als Verarbeitungssignal über einen Verarbeitungssignalausgang der Aufbereitungseinheit ausgegeben und anschließend über einen Verarbeitungssignaleingang einer Schalteinheit zugeführt. Dabei wird die Schalteinheit in Abhängigkeit des Verarbeitungssignals geschaltet, wobei in einem Schaltzustand der Schalteinheit die Versorgungsspannung als Ausgangssignal an einem Schaltausgang anliegt.

Gemäß einer vorteilhaften Ausgestaltung des Verfahrens ist vorgesehen, dass das Ausgangssignal als industrietechnisch standardisiertes Ausgangssignal ausgegeben wird. Dadurch wird erreicht, dass standardisierte speicherprogrammierbare Steuerungen und Relais mit einem derartigen Ausgangssignal direkt angesteuert werden können.

Gemäß einer weiteren vorteilhaften Ausgestaltung des Verfahrens ist vorgesehen, dass die Aufbereitung des Messsignals die Verstärkung des Messsignals und/oder den Vergleich des Messsignals oder verstärkten Messsignals mit einem Referenzsignal vorsieht. Im Rahmen eines derartigen Vergleichs kann ebenfalls vorgesehen sein, dass eine Wandlung des analogen Signals in ein digitales Signal erfolgt.

Verschiedene Aspekte der erfindungsgemäßen Lehre sind in den Zeichnungen schematisch dargestellt und werden nachfolgend beispielhaft erläutert.

Es zeigen:
- Figur 1: eine schematische Darstellung einer Innenansicht eines erfindungsgemäßen Spannungssensors gemäß einer ersten Ausführungsform; und
- Figur 2: eine schematische perspektivische Darstellung eines erfindungsgemäßen Spannungssensors in einer zweiten Ausführungsform.

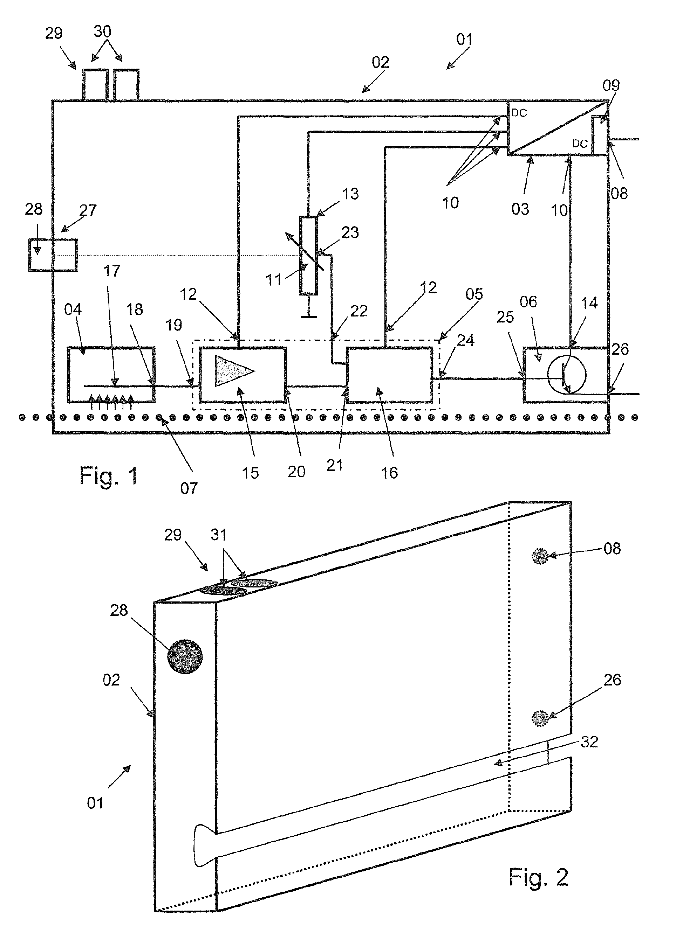

Figur 1 zeigt einen erfindungsgemäßen Spannungssensors 01, der ein Gehäuse 02 aufweist. Im Inneren des Gehäuses 02 ist die Versorgungseinheit 03, die Messeinheit 04, die Aufbereitungseinheit 05 sowie die Schalteinheit 06 angeordnet. Die punktierte Linie im unteren Bereich des Gehäuses 06 stellt die zu messende, isolierte elektrische Leitung 07 dar.

Die Versorgungseinheit 03 weist einen Versorgungseingang 08 auf, mit der der Sensor 01 bzw. die Versorgungseinheit 03 an eine externe, nicht dargestellte elektrische Versorgungsquelle angeschlossen werden kann. Die externe Versorgungsquelle kann zum Beispiel eine Versorgungsspannung mit Spannungswerten zwischen 9 und 30 Volt Gleichspannung liefern. Diese Spannung kann dann am Versorgungseingang bzw. An der Versorgungseinheit anliegen. Der Versorgungseingang kann dabei wie in Figur 1 angedeutet als eine Buchse ausgestaltet sein. Alternativ oder additiv kann der Versorgungseingang jedoch auch ein Kabel mit einem entsprechenden Stecker aufweisen, was jedoch in Figur 1 nicht dargestellt ist. Die Versorgungseinheit 03 weist zudem ein Verpolschutzmittel 09 auf, welches sicherstellt, dass der Sensor 01 unabhängig von der Polung der am Versorgungseingang 08 anliegenden Spannung betrieben werden kann. Zudem weist die Versorgungseinheit 03 Versorgungsausgänge 10 vor, die sowohl zur Versorgung der Aufbereitungseinheit 05 mit elektrischer Leistung, zur Erzeugung eines Referenzsignals mittels der Einstelleinheit 11 als auch zur Beaufschlagung der an der Versorgungseinheit 03 anliegenden Spannung an der Schalteinheit 06 mit jeweiligen Versorgungseingängen 12, 13, 14 verschaltet sind.

Gemäß der Ausführungsform der Figur 1 sind zwei der Versorgungsausgänge 10 der Versorgungseinheit 03 mit den Versorgungseingängen 12 der Aufbereitungseinheit 05 verbunden, wobei der erste Versorgungseingang 12 zur Versorgung der Verstärkungseinheit 15 und der zweite Versorgungseingang 12 zur Versorgung der Vergleichseinheit 16 dient.

Die Messeinheit 04 des Sensors 01 weist ein kapazitives Messelement 17 in Form einer offenen Elektrode auf, welches ein Messsignal erzeugt. Das Messsignal wird über den Messsignalausgang 18 ausgegeben und vom Messsignaleingang 19 von der Aufbereitungseinheit 05 aufgenommen.

Gemäß der Ausführungsform der Figur 1 erfolgt dabei im Rahmen der Aufbereitung des Messsignals mittels der Aufbereitungseinheit zunächst eine Verstärkung des Signals durch die Verstärkungseinheit 15, wobei die zur Signalverstärkung benötigte elektrische Leistung über den Versorgungseingang 12 von der Versorgungseinheit 03 bereitgestellt wird. Das so verstärkte Messsignal wird abermals über den Signalausgang 20 ausgegeben und über den Signaleingang 21 der Vergleichseinheit 16 zugeführt. Die Vergleichseinheit 16 vergleicht dabei das Signal am Signaleingang 21 mit dem Referenzsignal, welches am Referenzsignaleingang 22 anliegt.

Das Referenzsignal wird dabei durch einen Referenzsignalausgang 23 der Einstelleinheit bereitgestellt. Die Vergleichseinheit 16 kann dabei einen in Figur 1 nicht dargestellten Analog-Digital-Wandler umfassen, der in Abhängigkeit des Vergleichs der Signale am Signaleingang 21 am Referenzsignaleingang 22 ein digitales Signal über den Verarbeitungssignalausgang 24 ausgibt.

Über die Verschaltung bzw. Verbindung des Verarbeitungssignalausgangs 24 der Aufbereitungseinheit 05 mit dem Verarbeitungssignaleingang 25 der Schalteinheit 06 wird ermöglicht, das Verarbeitungssignal als Schaltsignal für die Schalteinheit 06 zu verwenden. Da an einem Versorgungseingang 14 der Schalteinheit 06 die an der Versorgungseinheit anliegende externe Spannung anliegt, kann bei einer entsprechenden Schaltung der Schalteinheit bzw. bei einer entsprechenden Überführung der Schalteinheit in einen von zumindest zwei Schaltzuständen erreicht werden, dass die der Versorgungseinheit anliegende externe Spannung am Schaltausgang 26 des Spannungssensors 01 bzw. der Schalteinheit 06 anliegt. Damit kann erreicht werden, dass das Ausgangssignal des Schaltausgangs 26 für speicherprogrammierbare Steuerungen oder Relais verwendet werden kann. Dabei kann der Schaltausgang 26, in Figur 1 nicht dargestellt, so angepasst werden, dass das Signal am Schaltausgangs 26 einem industrietechnischen Standard entspricht.

Um die Empfindlichkeit des Spannungssensors 01 extern durch einen Benutzer einstellen zu können, muss die Einstelleinheit 11, die beispielsweise als Potentiometer ausgeführt sein kann, mit einem Einstellmittel 27 verbunden, wie über die punktierte Linie in Figur 1 dargestellt. Das Einstellmittel 27 weist dabei ein auf der Außenseite des Gehäuses 02 angebrachtes Bedienelement 28 auf, womit über das Einstellmittel 27 sowie die Einstelleinheit 11 das Referenzsignal eingestellt werden kann, welches am Referenzsignal 23 der Einstelleinheit ausgegeben wird. Das Bedienelement 28 kann dabei zum Beispiel als Drehknopf oder als Stellschraube oder dergleichen ausgebildet sein und kann so ausgeführt sein, dass eine stufenlose oder eine abgestufte Einstellung der Einstelleinheit 11 mittels des Einstellmittels 27 ermöglicht wird.

Weiter zeigt die Figur 1 eine schematische Darstellung in einer Anzeigeeinheit 29, die ebenfalls an der Außenseite des Gehäuses 02 angeordnet ist und zwei Leuchtdioden 30 aufweist. Die Leuchtdioden können dabei beispielsweise als grüne Leuchtdiode und rote Leuchtdiode ausgestaltet sein und derart mit den restlichen Einheiten des Sensors geschaltet sein, dass der Zustand der zu messenden isolierten elektrischen Leitung 07, beispielsweise in Abhängigkeit des Schaltzustands der Schalteinheit 06 an der Anzeigeeinheit 29 kennbar ist bzw. abgelesen werden kann.

Figur 2 zeigt eine schematische perspektivische Darstellung des Gehäuses 02 des Sensors 01. Ebenfalls in Figur 2 schematisch dargestellt ist die Anzeigeeinheit 29, wobei gemäß der Ausführungsform der Figur 2 die Anzeigeeinheit 29 in das Gehäuse 02 des Sensors integriert ist und die Leuchtdioden 30 der Anzeigeeinheit 29 im Inneren des Gehäuse 02 angeordnet und deshalb in Figur 2 nicht dargestellt sind, die Leuchtdioden bzw. deren Zustand jedoch durch Sichtfenster 31 im Gehäuse 02 erkennbar sind.

Zudem in Figur 2 abgebildet ist eine schematische Darstellung des Bedienelements 28 an der Außenseite des Gehäuses 02. Zudem ist der Versorgungseingang 08 sowie der Schaltausgang 26 des Sensors 01, die sich in der Darstellung der Figur 2 jeweils auf der Rückseite des Gehäuses 02 befinden, entsprechend stilisiert dargestellt.

Weiter zeigt die Figur 2 ein Befestigungsmittel 32. In der Darstellung der Figur 2 ist das Befestigungsmittel 32 als Ausnehmung bzw. als Nut des Gehäuses 02 ausgestaltet, wobei die Ausgestaltung der Ausnehmung derart ist, dass mittels des Befestigungsmittels 32 ein Klemmsitz der zu messenden isolierten elektrischen Leitung an dem Gehäuse 02 ermöglicht wird. Aus der Darstellung der Figur wird ersichtlich, dass die Anordnung eines Befestigungsmittels auf der Außenseite des Gehäuses auch derart zu verstehen ist, dass das Befestigungsmittel durch das Gehäuse selbst oder durch einen Teil des Gehäuses gebildet wird. Befestigungsmittel können aber ebenfalls auch so vorgesehen sein, dass sie vom Gehäuse unabhängig sind, jedoch auf dessen Außenseite angeordnet sind.

Um eine zu messende elektrische Leitung dauerhaft oder zumindest temporär mittels einem Befestigungsmittel 32 an dem Sensor 01 bzw. an dessen Gehäuse 02 zu befestigen, können jedoch auch alternative Befestigungsmittel, wie beispielsweise Schlaufen, Haken oder Ösen verwendet werden, solange sie grundsätzlich dazu geeignet sind, eine zeitlich stabile relative räumliche Positionierung der zu messenden elektrischen Leitung in Bezug auf die Messeinheit des Sensors zu ermöglichen.

## Patentansprüche

1. Spannungssensor (01) zum kontaktlosen Messen der Spannung einer isolierten elektrischen Leitung (07), umfassend eine Versorgungseinheit (03) zur Aufnahme elektrischer Leistung mit einem Versorgungseingang (08) und zumindest einem Versorgungsausgang (10), eine Messeinheit (04) mit einem Messsignalausgang (18) zur kontaktlosen Messung von Spannung, eine Aufbereitungseinheit (05) mit einem Messsignaleingang (19) sowie zumindest einem Versorgungseingang (12) und einem Verarbeitungssignalausgang (24) und einer Schalteinheit (06) mit einem Versorgungseingang (14), einem Verarbeitungssignaleingang (25) und einem Schaltausgang (26),
**dadurch gekennzeichnet,**
**dass** die Schalteinheit (06) zumindest einen Schaltzustand aufweist, in dem die an der Versorgungseinheit (03) anliegende Spannung am Schaltausgang (26) anliegt.

2. Spannungssensor nach Anspruch 1,
**dadurch gekennzeichnet,**
**dass** der Schaltausgang (26) und/oder ein Signalausgang des Spannungssensors (01) als industrietechnisch standardisierter Schaltausgang (26) ausgelegt ist.

3. Spannungssensor nach einem der Ansprüche 1 oder 2,
**dadurch gekennzeichnet,**
**dass** die Messeinheit (04) ein kapazitives Messelement (17), insbesondere eine offene Elektrode aufweist.

4. Spannungssensor nach einem der Ansprüche 1 bis 3,
**dadurch gekennzeichnet,**
**dass** der Spannungssensor (01) ein Gehäuse (02) aufweist, insbesondere mit auf einer Außenseite des Gehäuses (02) angeordneten Befestigungsmittel (32) zur Befestigung der zu messenden Leitung (07).

5. Spannungssensor nach einem der Ansprüche 1 bis 4,
**dadurch gekennzeichnet,**
**dass** die Aufbereitungseinheit (05) eine Verstärkungseinheit (15) und eine Vergleichseinheit (16) aufweist, wobei die Verstärkungseinheit (15) das Messsignal des Messsignaleingangs (19) verstärkt und an einem Signalausgang (20) ausgibt und die Vergleichseinheit (16) einen Referenzsignaleingang (22) aufweist und das an einem Signaleingang (21) anliegende Signal mit der am Referenzsignalsignaleingang (22) anliegenden Signal vergleicht und in Abhängigkeit des Vergleichs ein Verarbeitungssignal über den Verarbeitungssignalausgang (24) ausgibt.

6. Spannungssensor nach Anspruch 5,
**dadurch gekennzeichnet,**
**dass** die Vergleichseinheit (16) einen Analog-Digital-Wandler aufweist und in Abhängigkeit des Vergleichs ein digitales Verarbeitungssignal über den Verarbeitungssignalausgang (24) ausgibt.

7. Spannungssensor nach einem der Ansprüche 1 bis 6,
**dadurch gekennzeichnet,**
**dass** der Spannungssensor (01) eine Einstelleinheit (11) mit einem Referenzsignalausgang (23) aufweist, mittels derer das Referenzsignal aus der an der Versorgungseinheit (03) anliegenden Spannung erzeugt und am Referenzsignalausgang (23) ausgegeben wird.

8. Spannungssensor nach Anspruch 7,
**dadurch gekennzeichnet,**
**dass** der Spannungssensor (01) ein Einstellmittel (27) aufweist, mit dem das in der Einstelleinheit (11) erzeugte Referenzsignal eingestellt wird.

9. Spannungssensor nach Anspruch 8,
**dadurch gekennzeichnet,**
**dass** das Einstellmittel (27) ein Bedienelement (28) aufweist, welches auf der Außenseite des Gehäuses (02) angebracht ist.

10. Spannungssensor nach einem der Ansprüche 1 bis 9,
**dadurch gekennzeichnet,**
**dass** der Spannungssensor (01) ein Anzeigeeinheit (29) aufweist, welches den Schaltzustand der Schalteinheit (06) anzeigt.

11. Spannungssensor nach Anspruch 10,
**dadurch gekennzeichnet,**
**dass** die Anzeigeeinheit (29) zumindest eine Leuchtdiode (30) aufweist.

12. Spannungssensor nach einem der Ansprüche 1 bis 11,
**dadurch gekennzeichnet,**
**dass** die Versorgungseinheit (03) einen Verpolschutzmittel (09) aufweist.

13. Verfahren zur kontaktlosen Spannungsmessung eine isolierten elektrischen Leitung (07) mittels eines Spannungssensors (01) umfassend die Verfahrensschritte:
- kapazitive Messung einer isolierten elektrischen Leitung mittels einer Messeinheit (04) und Ausgabe eines Messsignals über einen Messsignalausgang (18) der Messeinheit (04);
- Aufnahme eines Messsignals an einem Messsignaleingang (19) einer Aufbereitungseinheit (05);
- Aufbereitung, des Messsignals mittels der Aufbereitungseinheit (05) unter Verwendung einer Versorgungsspannung und Ausgabe eines Verarbeitungssignals mittels eines Verarbeitungssignalausgangs der Aufbereitungseinheit (05);
- Schaltung einer Schalteinheit (06) in Abhängigkeit des Aufbereitungssignals, wobei in einem Schaltzustand der Schalteinheit (06) die Versorgungsspannung als Ausgangssignal an einem Schaltausgang (26) anliegt.

14. Verfahren nach Anspruch 13,
**dadurch gekennzeichnet,**
**dass** das Ausgangssignal als industrietechnisch standardisiertes Ausgangssignal ausgegeben wird.

15. Verfahren nach einem der Ansprüche 13 oder 14,
**dadurch gekennzeichnet,**
**dass** die Aufbereitung des Messsignals die Verstärkung und den Vergleich mit einer Referenzsignal vorsieht.
